# EUROPEAN PATENT APPLICATION

(11) **EP 4 564 451 A2**
(43) Date of publication of application: **04.06.2025**
(21) Application number: 24216516.5
(22) Date of filing: 29.11.2024
(51) Int. Cl.: H01M 4/131, H01M 4/525, H01M 4/36, H01M 4/02

(54) **ACTIVE MATERIAL FOR POSITIVE ELECTRODE OF LITHIUM SECONDARY BATTERY AND LITHIUM SECONDARY BATTERY INCLUDING THE SAME**

(30) Priority: 01.12.2023 KR 20230172412
(71) Applicant: SAMSUNG SDI CO., LTD., Yongin-si, Gyeonggi-do 17084 (KR)
(72) Inventor: CHAE, Young Joo, 16678 Suwon-si (KR); KIM, Min Han, 16678 Suwon-si (KR); KIM, Jin Hwa, 16678 Suwon-si (KR); SEOG, Ji Hyun, 16678 Suwon-si (KR)
(74) Representative: Marks & Clerk LLP

(57) **Abstract**

A positive electrode material for lithium secondary batteries and a lithium secondary battery including the same are disclosed. The positive electrode material includes: i) a first secondary particle having a size in a range of 13 µm to 20 µm and containing an agglomerate of primary particles having a size in a range of 1 µm or less; ii) a second secondary particle having a size in a range of 7 µm to 13 µm and containing an agglomerate of primary particles having a size in a range of 1 µm or less; and iii) a one-body particle having a size in a range of 1 µm to 7 µm and containing primary particles, wherein a nickel content of each of the particles satisfies Relation 1: nickel content of the one-body particle > nickel content of the first secondary particle > nickel content of the second secondary particle.

## Description

### BACKGROUND

### 1. Field

One or more aspects of embodiments of the present disclosure are directed toward an active material for a positive electrode of a lithium secondary battery and a lithium secondary battery including the positive electrode active material.

### 2. Description of the Related Art

In recent years, demand for high energy density and high capacity secondary batteries has significantly increased in response to a rapid increase in the use of battery-powered electronic devices, such as mobile phones, notebook computers, and/or electric vehicles. Thus, research and development aimed at improving performance of lithium secondary batteries has been steadily on-going.

A lithium secondary battery includes a positive electrode and a negative electrode, both of which contain active materials that allow for intercalation and deintercalation of lithium ions, and an electrolyte. The lithium battery produces electricity through oxidation and reduction reactions upon intercalation/deintercalation of the lithium ions in the positive electrode and the negative electrode.

As a positive electrode material, a nickel-based active material having a suitably high nickel content and good or suitable capacity characteristics may be used.

### SUMMARY

One or more aspects of embodiments of the present disclosure provide a positive electrode material for lithium secondary batteries that has good or suitable characteristics in terms of capacity and lifespan at a relatively high temperature, reduces resistance in electrochemical reaction, allows homogenized (or substantially homogenized) electrochemical reaction, and suppresses or reduces outgassing.

One or more aspects of embodiments of the present disclosure provide a lithium secondary battery including the active material for the positive electrode of the lithium secondary battery.

In accordance with one or more aspects of embodiments of the present disclosure,

an active material of the positive electrode (e.g., for lithium secondary batteries) includes: i) a first secondary particle having a size in a range of 13 µm to 20 µm and containing an agglomerate of primary particles having a size in a range of 1 µm or less; ii) a second secondary particle having a size in a range of 7 µm to 13 µm and containing an agglomerate of primary particles having a size in a range of 1 µm or less; and iii) a one-body particle having a size in a range of 1 µm to 7 µm and containing primary particles (e.g., consisting of primary particles), wherein a nickel content of each of the first secondary particle, the second secondary particle, and the one-body particle satisfies Relation 1: nickel content of the one-body particle > nickel content of the first secondary particle > nickel content of the second secondary particle.

In some embodiments, the positive electrode material may satisfy Relation 2: size of the first secondary particle > size of the second secondary particle > size of the one-body particle.

In some embodiments, the positive electrode material may have a nickel content of 94 mol% or more based on the total content of metals in the positive electrode material excluding lithium.

In some embodiments, the first secondary particle may have the nickel content of 85 mol% to 97 mol%.

In some embodiments, the second secondary particle may have the nickel content of 80 mol% to 90 mol%.

In some embodiments, the one-body particle may have the nickel content of 90 mol% to 99 mol%.

In some embodiments, the one-body particle may be present in an amount of 5 to 25 parts by weight relative to 100 parts by weight of the first secondary particle.

In some embodiments, the first secondary particle may be present in an amount of 60 to 80 parts by weight relative to 100 parts by weight of the first secondary particle.

In some embodiments, the second secondary particle is present in an amount of 5 to 35 parts by weight relative to 100 parts by weight of the first secondary particle.

In some embodiments, the first secondary particle, the second secondary particle, and the one-body particle may be present in a total amount of 95 wt% or more in the positive electrode material.

In some embodiments, the first secondary particle may have a nickel content of 85 mol% to 97 mol%, the second secondary particle may have a nickel content of 80 mol% to 90 mol%, and the one-body particle may have a nickel content of 90 mol% to 99 mol%.

In some embodiments, the first secondary particle may be present in an amount of 60 to 80 parts by weight, the second secondary particle may be present in an amount of 5 to 35 parts by weight, and the one-body particle may be present in an amount of 5 to 25 parts by weight relative to 100 parts by weight of the positive electrode material.

In some embodiments, a mole ratio of the nickel content of the first secondary particle to the nickel content of the second secondary particle may be in a range from 1.01 to 1.06.

In some embodiments, a mole ratio of the nickel content of the first secondary particle to the nickel content of the one-body particle may be in a range from 0.94 to 0.99.

In some embodiments, the positive electrode material includes a compound represented by Formula 1 or a compound represented by Formula 2:

Formula 1 LiₓNi_{1-y}Co_{y}O_{2-z}X_{z},

where in Formula 1, x, y and z satisfy relations: 0.9≤x≤1.2, 0<y≤0.2, 0≤z≤0.5, and 0.8≤1-y<1, and X denotes F, S, P or a combination thereof,

   Formula 2 LiₓNi_{1-y-z}Co_{y}M_{z}O₂₋ₐXₐ,

   and
where in Formula 2, x, y, z and a satisfy relations: 0.9≤x≤1.2, 0<y<0.5, 0.8≤1-y-z<1,0≤z≤0.5, 0<y+z≤0.2, and 0≤a<2;
M denotes Mn, Mg, Ca, Sr, Ba, Ti, Zr, Nb, Mo, W, Zn, Al, Si, Cr, Fe, V, a rare-earth element or a combination thereof; and
X denotes F, S, P or a combination thereof.

In some embodiments, the positive electrode material includes a compound represented by Formula 3 or a compound represented by Formula 4:

Formula 3 LiₓCoₐNi_{b}Mn_{c}O₂,

where in Formula 3, x, a, b and c satisfy relations: 0.9<x≤1.2, 0<a<0.5, 0.8≤b<1, 0<c<0.5, and a+b+c=1,

   Formula 4 LiₓCoₐNi_{b}Al_{c}O₂,

   and
where in Formula 4, x, a, b and c satisfy relations: 0.9<x≤1.2, 0<a<0.5, 0.8≤b<1, 0<c<0.5, and a+b+c=1.

In some embodiments, at least one of the first secondary particle, the second secondary particle, or the one-body particle may include a cobalt coating layer on a surface thereof.

According to one or more embodiments of the present disclosure, a lithium secondary battery includes: a positive electrode including the active material for the positive electrode as described herein; a negative electrode; and an electrolyte.

At least some of the above and other features of the invention are set out in the claims.

Embodiments of the present disclosure provide an active material for a positive electrode of a lithium secondary battery that has good or suitable characteristics in terms of capacity and lifespan at a relatively high temperature, allows homogenized (or substantially homogenized) electrochemical reaction, and suppresses or reduces outgassing.

### BRIEF DESCRIPTION OF THE DRAWINGS

FIG. 1-FIG. 4 are each a schematic cross-sectional view of a lithium secondary battery according to one or more embodiments of the present disclosure.
FIG. 5 is a scanning electron micrograph (SEM) image of an active material for the positive electrode prepared in Example 1.
FIG. 6 is a graph depicting high temperature lifespan characteristics of lithium secondary batteries of Examples and Comparative Examples.

### DETAILED DESCRIPTION

Hereinafter, example embodiments of the present disclosure will be described in more detail with reference to the accompanying drawings. However, it should be understood that the following embodiments are provided by way of illustration and the present disclosure is not limited thereto and is defined only by the appended claims and equivalents thereto.

When an element is referred to as being arranged (or located or positioned) "above" (or "below") or "on" (or "under") a component, it may refer to a case where the element is placed in contact with the upper (or lower) surface of the component, and may also refer to a case where another (e.g., additional) component may be interposed between the first component and the element arranged (or located or positioned) on (or under) the component.

Throughout the specification, unless specified otherwise, each element may be singular or plural. In addition, the term "and/or" includes any and all combinations of one or more of the associated listed items. For example, throughout the specification, if (e.g., when) "A and/or B" is stated, it refers to only A, only B, or A and B, unless specified otherwise.

As used herein, expressions such as "at least one of", "one of", and "selected from", when preceding a list of elements, modify the entire list of elements and do not modify the individual elements of the list. For example, "at least one selected from among a, b and c", "at least one of a, b or c", and "at least one of a, b and/or c" may indicate only a, only b, only c, both (e.g., simultaneously) a and b, both (e.g., simultaneously) a and c, both (e.g., simultaneously) b and c, all of a, b, and c, or variations thereof. Further, the use of "may" when describing embodiments of the present disclosure refers to "one or more embodiments of the present disclosure".

As used herein, "combinations thereof" may refer to mixtures, stacks, composites, copolymers, alloys, blends, and/or reaction products of components.

Unless otherwise defined herein, particle diameter may refer to an average particle diameter. In one or more embodiments, the particle diameter refers to an average particle diameter (D50) that refers to a particle diameter corresponding to 50% by volume in a volume cumulative distribution of corresponding particles. The average particle diameter may be measured by any suitable method, for example, a particle size analyzer, a transmission electron microscope (TEM) image (e.g., photography) and/or a scanning electron microscope (SEM) image (e.g., photography). In one or more embodiments, the average particle diameter (D50) may be measured by counting the number of particles in each particle diameter range using a device employing a dynamic light-scattering method to analyze data, followed by calculating the average particle diameter (D50) based on the analyzed data. In one or more embodiments, the average particle diameter (D50) may be measured by laser diffraction. More specifically, in measurement by laser diffraction, target particles are dispersed in a dispersant, introduced into a commercially available laser diffraction particle analyzer (for example, Micro-Trac MT-3000^{™}), and irradiated with ultrasound waves of about 28 kHz at a power of 60 W, followed by calculating the average particle size (D50) corresponding to 50 vol% by volume in the cumulative volume distribution of the particles in the measurement device. In the present specification, when particles are spherical, "diameter" indicates a particle diameter, and when the particles are non-spherical, the "diameter" indicates a major axis length.

Herein, "nickel content" may refer to a mole ratio of the content (e.g., amount) of nickel to the total content (e.g., amount) of all metals excluding lithium in a positive electrode material.

As used herein to represent a specific numerical range, "X to Y" refers to a value greater than or equal to X and less than or equal to Y (X≤ and ≤ Y).

It will be further understood that the terms "includes," "including," "comprises," and/or "comprising," when used in this specification, specify the presence of stated features, steps, operations, elements, and/or components, but do not preclude the presence or addition of one or more other features, steps, operations, elements, components, and/or groups thereof.

As used herein, the terms "use," "using," and "used" may be considered synonymous with the terms "utilize," "utilizing," and "utilized," respectively.

Spatially relative terms, such as "beneath," "below," "lower," "above," "upper," "bottom," "top" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

As used herein, the terms "substantially", "about", and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

### Positive electrode material for lithium secondary batteries

A positive electrode material for lithium secondary batteries according to one or more embodiments includes: i) a first secondary particle having a size (e.g., average particle diameter D50) in a range of 13 µm to 20 µm and containing an aggregate of primary particles each having a size (e.g., average particle diameter D50) in a range of 1 µm or less; ii) a second secondary particle having a size (e.g., average particle diameter D50) in a range of 7 µm to 13 µm and containing an aggregate of primary particles each having a size (e.g., average particle diameter D50) in a range of 1 µm or less; and iii) a one-body particle having a size (e.g., average particle diameter D50) in a range of 1 µm to 7 µm and containing primary particles (e.g., consisting of primary particles).

Herein, the term "size" refers to an average diameter of positive electrode material particles for lithium secondary batteries if (e.g., when) the positive electrode material particles are spherical. When the positive electrode material particles are not spherical, the term "size" refers to the maximum value among major axis lengths that can be obtained from cross-sections of the particles.

The average particle diameter can be measured by, for example, a particle size distribution (PSD) instrument and/or by SEM. Unless otherwise defined, the average particle diameter refers to a particle diameter (D50) corresponding to 50% by volume in a cumulative volume variation in a particle size distribution. The major axis lengths can be measured by, for example, SEM and/or the like.

Herein, "one-body particle" refers to a structure in which particles form morphologically distinct phases that are not mutually agglomerated. In contrast to the one-body particle, there is a particle structure in which small particles (primary particles) are physically and/or chemically agglomerated to form relatively large particles (secondary particles). The "one-body particle" has a structure in which a number of crystalline particles is dispersed and/or separated from each other such that each particle forms an independent and/or distinct phase rather than an aggregated phase, and may also include a structure in which 10 or fewer particles are attached to (but not agglomerated with) each other. For example, the one-body particle may exist alone or as an aggregate of a plurality of one-body particles. For example, the one-body particle may be an aggregate of two to ten one-body particles in contact (but not agglomerated) with each other.

The positive electrode material for lithium secondary batteries according to the embodiments satisfy a nickel content (e.g., amount) relation between the first secondary particle, the second secondary particle, and the one-body particle, as expressed by Relation 1. Nickel content of one-body particle > Nickel content of first secondary particle > Nickel content of second secondary particles

The first secondary particle may have a relatively fast lithium diffusion rate, but also may experience an unsuitably fast degradation rate, thus leading to an undesirable reduction in the lifespan of the lithium secondary battery. The second secondary particle according to the present embodiments can help mitigate the problems of the first secondary particle. The second secondary particle has a lower nickel content than the first secondary particle and thus can solve, or help mitigate, the problem of degradation. The one-body particle has a higher nickel content than the first secondary particle and the second secondary particle. The one-body particle can increase the lithium diffusion rate, which can otherwise be reduced due to the presence of the secondary particles.

According to one or more embodiments, the positive electrode material for lithium secondary batteries has a nickel content of 94 mol% or more based on the total content (e.g., amount) of metals excluding lithium therein.

The positive electrode material for lithium secondary batteries including the first secondary particle, the second secondary particle, and the one-body particle may satisfy the nickel content relation between the first secondary particle, the second secondary particle, and the one-body particle as expressed by Relation 1, and may have a nickel content of 94 mol% or more, and thus can have remarkable effects (e.g., desirable results) of improved capacity characteristics and lifespan at a relatively high temperature while suppressing or reducing outgassing.

For example, the positive electrode material for lithium secondary batteries may have a nickel content of 94 mol% to 99 mol%, 95 mol% to 98 mol%, or 95 mol% to 98 mol%.

According to one or more embodiments, in the positive electrode material for lithium secondary batteries, the second secondary particle can significantly or suitably improve capacity and lifespan characteristics if (e.g., when) the one-body particle is present in an amount of 5 to 25 parts by weight relative to 100 parts by weight of the first secondary particle. For example, the one-body particle may be present in an amount of 5, 6, 7, 8, 9, 10, 11, 12, 13, 14, 15, 16, 17, 18, 19, 20, 21, 22, 23, 24, 25 parts by weight, 10 to 25 parts by weight, 10 to 20 parts by weight, or 15 to 20 parts by weight, relative to 100 parts by weight of the first secondary particle.

The first secondary particle refers to a secondary particle having a size of 13 µm to 20 µm and formed through physical and/or chemical agglomeration of primary particles having a size of 1 µm or less. If the size of the first secondary particle is less than 13 µm, there can be a problem of deterioration in energy density, and if the size of the first secondary particle exceeds 20 µm, there can be a problem of deterioration in battery lifespan due to collision and/or cracking between the second secondary particles during the process of rolling of an electrode plate. For example, the first secondary particle may have a size of 13, 14, 15, 16, 17, 18, 19, 20 µm, 14 µm to 20 µm, 15 µm to 20 µm, or 16 µm to 20 µm.

In the first secondary particle, the primary particles may have an average particle diameter of 0.01 µm to 1 µm, 0.02 µm to 0.8 µm, 0.03 µm to 0.5 µm, 0.04 µm to 0.1 µm, or 0.05 µm to 0.07 µm (50 nm to 70 nm). According to one or more embodiments, the first secondary particle may have a polycrystalline structure. As used herein, "polycrystalline" refers to an agglomerated structure of a plurality of crystalline particles.

The one-body particle may have a size of 1 µm to 7 µm, for example, 1, 2, 3, 4, 5, 6, 7 µm, and may contain primary particles. The primary particles may have an average particle diameter of 0.01 µm to 1 µm, 0.02 µm to 0.8 µm, 0.03 µm to 0.5 µm, 0.04 µm to 0.1 µm, or 0.05 µm to 0.07 µm (50 nm to 70 nm).

The second secondary particle refers to a secondary particle having a size of 7 µm to 13 µm and formed through physical and/or chemical agglomeration of primary particles having a size of 1 µm or less. The second secondary particle has a smaller size than the first secondary particles. If the size of the second secondary particles is less than 7 µm, or if it exceeds 13 µm, the positive electrode can have poor or unsuitable composite density. For example, the second secondary particles may have a size of 7, 8, 9, 10, 11, 12, 13 µm, 7 µm to 12 µm, or 8 µm to 12 µm.

In the second secondary particle, the primary particles may have an average particle diameter of 0.01 µm to 1 µm, 0.02 µm to 0.8 µm, 0.03 µm to 0.5 µm, 0.04 µm to 0.1 µm, or 0.05 µm to 0.07 µm (50 nm to 70 nm). According to one or more embodiments, the second secondary particle may have a polycrystalline structure.

According to one or more embodiments, the positive electrode material for lithium secondary batteries may satisfy Relation 2. Size of first secondary particle > Size of second secondary particle > Size of one-body particle

According to one or more embodiments, the first secondary particle may have a nickel content (e.g., amount) of 85 mol% to 97 mol%. Within this range, the positive electrode material can easily or suitably satisfy Relation 1. For example, the first secondary particle may have a nickel content of 85, 86, 87, 88, 89, 90, 91, 92, 93, 94, 95, 96, 97 mol%, 90 mol% to 97 mol%, 94 mol% to 97 mol%, or 94 mol% to 97 mol%.

According to one or more embodiments, the second secondary particle may have a nickel content (e.g., amount) of 80 mol% to 90 mol%. Within this range, the positive electrode material can easily or suitably satisfy Relation 1. For example, the second secondary particle may have a nickel content of 80, 81, 82, 83, 84, 85, 86, 87, 88, 89, 90 mol%, 85 mol% to 90 mol%, 85 mol% to 89 mol%, or 85 mol% to 89 mol%.

According to one or more embodiments, the one-body particle may have a nickel content (e.g., amount) of 90 mol% to 99 mol%. Within this range, the positive electrode material can easily or suitably satisfy Relation 1. For example, the one-body particle may have a nickel content of 90, 91, 92, 93, 94, 95, 96, 97, 98, 99 mol%, 95 mol% to 99 mol%, 95 mol% to 97 mol%, or 95 mol% to 97 mol%.

According to one or more embodiments, the mole ratio of the nickel content of the first secondary particle to the nickel content of the second secondary particle may be in a range from 1.01 to 1.06, for example 1.01, 1.02, 1.03, 1.04, 1.05, 1.06. Within this range, the positive electrode material can help improve capacity and lifespan of the battery.

According to one or more embodiments, the mole ratio of the nickel content of the first secondary particle to the nickel content of the one-body particle may be in a range from 0.94 to 0.99, for example 0.94, 0.95, 0.96, 0.97, 0.98, 0.99. Within this range, the positive electrode material can help improve capacity and lifespan of the battery.

The average particle diameter of the primary particles constituting each of the first secondary particle, the second secondary particle, and the one-body particle may be determined by SEM. For example, the average particle diameter of the primary particles may be obtained by averaging particle diameters of 10 to 30 primary particles.

A positive electrode including the positive electrode material for lithium secondary batteries containing the first secondary particle, the second secondary particle, and the one-body particle can provide a lithium secondary battery that stabilizes or improves electrochemical reactivity, reduces outgassing at high voltage, and secures improvement in reliability, safety, and suitably high power and long lifespan characteristics.

The positive electrode material for lithium secondary batteries according to the embodiments may have an average particle size of, for example, 10 µm to 20 µm, for example 10, 11, 12, 13, 14, 15, 16, 17, 18, 19, 20 µm.

According to one or more embodiments, relative to the total of 100 parts by weight of the positive electrode material for lithium secondary batteries, the content (e.g., amount) of the first secondary particle may be higher than each of the second secondary particle and the one-body particle. The positive electrode material for lithium secondary batteries can further improve capacity if (e.g., when) it contains a higher content (e.g., amount) of the first secondary particle than each of the second secondary particle and the one-body particle.

According to one or more embodiments, the positive electrode material for lithium secondary batteries may include, for example, 60 to 80 parts by weight of the first secondary particle relative to the total sum of 100 parts by weight of the first secondary particle, the second secondary particle, and the one-body particle. Within this range, the positive electrode material can achieve improvement in capacity and lifespan characteristics. For example, the first secondary particle may be present in an amount of 60, 61, 62, 63, 64, 65, 66, 67, 68, 69, 70, 71, 72, 73, 74, 75, 76, 77, 78, 79, 80 parts by weight, 70 to 80 parts by weight, or 75 to 80 parts by weight relative to the total sum of 100 parts by weight of the first secondary particle, the second secondary particle, and the one-body particle (e.g., 60 to 75 parts by weight, 65 to 75 parts by weight, or 70 to 75 parts by weight).

According to one or more embodiments, the positive electrode material for lithium secondary batteries may include, for example, 5 to 35 parts by weight of the second secondary particle relative to the total sum of 100 parts by weight of the first secondary particle, the second secondary particle, and the one-body particle. Within this range, the positive electrode material can achieve improvement in capacity and lifespan characteristics. For example, the second secondary particle may be present in an amount of 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35 parts by weight, 5 to 30 parts by weight, 5 to 20 parts by weight, or 5 to 15 parts by weight relative to the total sum of 100 parts by weight of the first secondary particle, the second secondary particle, and the one-body particle (e.g., 10 to 35 parts by weight, 10 to 25 parts by weight, 10 to 20 parts by weight, or 10 to 15 parts by weight).

According to one or more embodiments, the positive electrode material for lithium secondary batteries may include, for example, 5 to 25 parts by weight of the one-body particle relative to the total sum of 100 parts by weight of the first secondary particle, the second secondary particle, and the one-body particle. Within this range, the positive electrode material can achieve improvement in capacity and lifespan characteristics. For example, the one-body particle may be present in an amount of 5, 6, 7, 8, 9, 10, 11, 12, 13, 14, 15, 16, 17, 18, 19, 20, 21, 22, 23, 24, 25 parts by weight, 10 to 25 parts by weight, or 10 to 20 parts by weight relative to the total sum of 100 parts by weight of the first secondary particle, the second secondary particle, and the one-body particle.

According to one or more embodiments, the first secondary particle, the second secondary particle, and the one-body particle may be present in a total amount of 95 wt% or more, for example, 98 wt% to 100 wt%, or 100 wt%, in the positive electrode material for lithium secondary batteries. Within this range, the positive electrode material for lithium secondary batteries can easily or suitably achieve the desired effects of these particles.

According to one or more embodiments, the positive electrode material for lithium secondary batteries may have a plate-like structure (e.g., in a form of a plate) with one or more suitable detailed (or set) shapes, for example, a polygonal nano-plate shape such as a spherical shape, an elliptical shape, a hexagonal shape, and/or the like; a nano-disc shape; a parallelepiped shape; and/or the like. When the positive electrode material for lithium secondary battery is not spherical, the size refers to a major axis length.

According to one or more embodiments, in the positive electrode material for lithium secondary batteries, each of the first secondary particle, the second secondary particle, and the one-body particle may be a lithium nickel-based composite oxide.

For example, the lithium nickel-based complex oxide may include a compound represented by Formula 1 or a compound represented by Formula 2.

Formula 1 LiₓNi_{1-y}Co_{y}O_{2-z}X_{z},

where x, y and z satisfy the following relations: 0.9≤x≤1.2, 0<y≤0.2, 0≤z≤0.5, and 0.8≤1-y<1; and X denotes F, S, P or a combination thereof.

   Formula 2 LiₓNi_{1-y-z}Co_{y}M_{z}O₂₋ₐXₐ,
where x, y, z and a satisfy the following relations: 0.9≤x≤1.2, 0<y<0.5, 0.8≤1-y-z<1,0≤z≤0.5, 0<y+z≤0.2, and 0≤a<2; M denotes Mn, Mg, Ca, Sr, Ba, Ti, Zr, Nb, Mo, W, Zn, Al, Si, Cr, Fe, V, a rare earth element, or a combination thereof; and X denotes F, S, P, or a combination thereof.

In Formulae 1 and 2, the lithium nickel-based complex oxide may have a nickel content (e.g., amount) of 80 mol% or more, for example, 80 mol% to 95 mol%, or 85 mol% to 92 mol%; x may be in a range from 1 to 1.05; and y may be in a range from, for example, 0.01 to 0.2. In Formula 2, M may denote Al, and z may be in a range, for example, from 0.01 to 0.05.

According to one or more embodiments, the lithium nickel-based complex oxide may be a compound represented by Formula 3 or a compound represented by Formula 4.

Formula 3 LiₓCoₐNi_{b}Mn_{c}O₂,
where x, a, b and c satisfy the following relations: 0.9<x≤1.2, 0<a<0.5, 0.8≤b<1, 0<c<0.5, and a+b+c=1.

   Formula 4 LiₓCoₐNi_{b}Al_{c}O₂,
where x, a, b and c satisfy the following relations: 0.9<x≤1.2, 0<a<0.5, 0.8≤b<1, 0<c<0.5, and a+b+c=1.

In Formulae 3 and 4, x may be in a range from 1.0 to 1.2, 1.0 to 1.1, or 1.0 to 1.05; a may be in a range from, for example, 0.001 to 0.45, 0.01 to 0.4, 0.01 to 0.3, 0.01 to 0.2, 0.01 to 0.1, 0.02 to 0.08, or 0.04 to 0.09; and b may be in a range from, for example, 0.8 to 0.99, 0.8 to 0.98, or 0.85 to 0.95. For example, c may be in a range from 0.001 to 0.3, 0.001 to 0.2, 0.001 to 0.1, 0.005 to 0.02, or 0.005 to 0.01.

According to one or more embodiments, the size of the positive electrode material for lithium secondary batteries may be adjusted to improve high temperature characteristics and rate capability and to reduce outgassing at high voltage while ensuring suitable reliability and safety upon implementation of a lithium secondary battery using the positive electrode material.

According to one or more embodiments, in a process of preparing the positive electrode material for lithium secondary batteries, the weight ratio of lithium to metals and heat treatment conditions (heat treatment temperature, atmosphere, and time) may be adjusted to control (e.g., vary) the size of the primary particles and the secondary particles of the positive electrode material so as to reduce the specific surface areas thereof, and residual lithium is removed as much as possible to suppress or reduce surface side reaction of the residual lithium and the electrolyte. In one or more embodiments, by controlling or conducting the preparation process as described above, it is possible to obtain a positive electrode material with improved crystallinity and stability at high voltage.

According to one or more embodiments, the positive electrode material for lithium secondary batteries may further include a cobalt coating layer. The cobalt coating layer can further improve lifespan characteristics of lithium secondary batteries while realizing higher or improved capacity.

According to one or more embodiments, at least one of the first secondary particle, the second secondary particle, or the one-body particle may include a cobalt coating layer on a surface thereof.

For example, the first secondary particle may include a cobalt coating layer on a surface of the secondary particle. The first secondary particle may include a cobalt coating layer on a surface of the primary particles and/or the secondary particle.

For example, the second secondary particle may include a cobalt coating layer on a surface of the secondary particle. The first secondary particle may include a cobalt coating layer on a surface of the primary particles and/or the secondary particle.

For example, the one-body particle may include primary particle(s); and a cobalt coating layer on a surface of the primary particle.

Next, a method of preparing the positive electrode material for lithium secondary batteries will be described.

According to one or more embodiments, a positive electrode material for lithium secondary batteries may be prepared by preparing a first secondary particle, a second secondary particle, and a one-body particle, followed by mixing these particles.

For example, each of the first secondary particle, the second secondary particle, and the one-body particle may be prepared by mixing a nickel-based active material precursor and a lithium precursor in a certain mole ratio to prepare a mixture, and subjecting the mixture to primary heat treatment.

The nickel-based active material precursor includes a nickel-based hydroxide, which may be prepared by co-precipitation of a nickel precursor and precursors of other transition metals. For example, the nickel-based active material precursor may be a hydroxide or oxide including nickel, cobalt, and other metals.

According to one or more embodiments, the nickel-based active material precursor may be prepared by mixing a nickel precursor, a cobalt precursor, and an aluminium precursor in a first solvent, followed by co-precipitation. The nickel precursor, the cobalt precursor, and the aluminium precursor may be any suitable substances available in the art. The content (e.g., amount) of each of the nickel precursor, the cobalt precursor, and the aluminium precursor may be stoichiometrically controlled or selected to obtain the compound of Formula 4.

The first solvent may be water, ethanol, propanol, butanol, and/or the like. The first solvent may be present in an amount of 100 to 2,000 parts by weight relative to 100 parts by weight of the total weight of the nickel precursor, the cobalt precursor, and the aluminium precursor.

The nickel-based active material precursor may be represented by, for example, Formula 5:

Formula 5 Ni_{1-y-z}Co_{y}M_{z}(OH)₂,

where y and z satisfy the following relations: 0<y<0.5, 0.8≤1-y-z<1,and 0≤z<0.5; and
M denotes Mn, Mg, Ca, Sr, Ba, Ti, Zr, Nb, Mo, W, Zn, Al, Si, Cr, Fe, V, a rare-earth element, or a combination thereof.

The lithium precursor may include, for example, lithium hydroxide, lithium fluoride, lithium carbonate, lithium sulfate, lithium nitrate, or mixtures thereof. The mixing ratio of the lithium precursor to the nickel-based active material precursor may be stoichiometrically adjusted to prepare, for example, the positive electrode material for lithium secondary batteries represented by Formula 2.

According to one or more embodiments, mixing of the lithium precursor and the nickel-based active material precursor may be carried out by dry mixing using a mixer and/or the like. Dry mixing may be performed by milling. Although milling conditions are not particularly limited, milling may be performed to allow little deformation (e.g., to reduce deformation), such as refinement of the precursor used as a starting material. The size of the lithium precursor to be mixed with the nickel-based active material precursor may be controlled or selected in advance. The lithium precursor may have a size (average particle diameter) of 5 µm to 15 µm, for example, about 10 µm. A desired or required mixture may be obtained by milling the lithium precursor having such a size with the nickel-based active material precursor at 300 to 3,000 rpm. When the inner temperature of a mixer rises above 30°C during the milling process, a cooling process may be performed to maintain the interior of the mixer at room temperature (25°C).

According to some embodiments, a second solvent may be used if (e.g., when) mixing the nickel-based active material precursor with the lithium precursor. Like the first solvent described above, the second solvent may include water, ethanol, butanol, propanol, and/or the like, and may be present in an amount of 100 to 2,000 parts by weight relative to 100 parts by weight of the lithium precursor. To the mixture containing the nickel-based active material precursor and the lithium precursor, a complexing agent and a pH regulator may be added and mixed therewith.

The primary heat treatment may be performed in air or under an oxygen atmosphere. The primary heat treatment may be performed, for example, at 600°C to 900°C, for example, at 650°C to 900°C.

The method of preparing the nickel-based active material may further include secondary heat treatment performed in air or under an oxygen atmosphere after the primary heat treatment. The secondary heat treatment may be performed, for example, at 600°C to 900°C.

According to one or more embodiments, in preparation of the first secondary particle, the primary heat treatment may be performed in air or under an oxygen atmosphere. The primary heat treatment may be performed, for example, at 600°C to 800°C, for example, at 650°C to 800°C.

According to one or more embodiments, in preparation of the second secondary particle, the primary heat treatment may be performed in air or under an oxygen atmosphere. The primary heat treatment may be performed, for example, at 600°C to 800°C, for example, at 650°C to 800°C.

According to one or more embodiments, in preparation of the one-body particle, the primary heat treatment may be performed in air or under an oxygen atmosphere. The primary heat treatment may be performed, for example, at 800°C to 900°C.

According to some embodiments, the positive electrode material for lithium secondary batteries may be prepared by mixing the first secondary particle, the second secondary particle, and the one-body particle to prepare a mixture, and performing cobalt coating on the mixture.

Because mixing of the first secondary particle, the second secondary particle and the one-body particle can be performed by the method described above, detailed description thereof will not be provided again. Hereinafter, only the cobalt coating process will be described.

Cobalt coating may be performed by dry coating and/or wet coating.

For example, dry coating of cobalt may be carried out by introducing a cobalt source into the mixture of the first secondary particle, the second secondary particle, and the one-body particle, followed by heat treatment.

For example, wet coating of cobalt may be carried out by introducing a solvent, such as distilled water, into the mixture of the first secondary particle, the second secondary particle, and the one-body particle, cleaning the mixture while mixing, and adding a cobalt source to the mixture.

The cobalt source may include, for example, cobalt hydroxide, cobalt carbonate, cobalt sulfate, cobalt oxide, cobalt nitrate, and/or the like.

The cobalt source may be added to the mixture such that each of the first secondary particle, the second secondary particle, and the one-body particle has a cobalt content (e.g., amount) of 0.01 parts by mole to 5 parts by mole, for example, 0.01 parts by mole to 3 parts by mole, or 0.1 parts by mole to 2.5 parts by mole. As a result, it is possible to form a cobalt coating layer in an appropriate or suitable content (e.g., amount).

After adding the cobalt source, the cobalt coating process may further include filtering the cobalt source to remove a solvent and drying the cobalt coating layer. Drying may be performed, for example, at a temperature of 100°C to 300°C for 5 hours to 15 hours, for example, at 200°C for 10 hours.

Then, the resulting product is mixed with a lithium source and fed into a furnace, followed by calcination at 650°C to 900°C, 650°C to 800°C, or 650°C to 800°C, in an oxygen atmosphere, for 5 hours to 30 hours, or for 10 hours to 24 hours.

### Lithium secondary battery

According to one or more embodiments, a lithium secondary battery includes a positive electrode including the positive electrode material for lithium secondary batteries according to the embodiments of the present disclosure; a negative electrode; and an electrolyte.

The positive electrode may include a current collector and a positive electrode material layer formed on the current collector. The positive electrode material layer may include a positive electrode material and may further include a binder and/or a conductive material.

In one or more embodiments, the positive electrode may further include an additive capable of acting as a sacrificial positive electrode.

The positive electrode material may be present in an amount of 90 wt% to 99.5 wt% based on 100 wt% of the positive electrode material layer, and each of the binder and the conductive material may be present in an amount of 0.5 wt% to 5 wt% based on 100 wt% of the positive electrode material layer.

The positive electrode material layer includes a positive electrode material according to one or more embodiments of the present disclosure.

In addition to the positive electrode material for lithium secondary batteries according to the present embodiments, the positive electrode material may further include a different positive electrode material.

The different positive electrode material according to one or more embodiments may include at least one composite oxide of lithium with a metal selected from among cobalt, manganese, nickel and combinations thereof.

The composite oxide may be a lithium transition metal composite oxide. For example, the composite oxide may include a lithium nickel oxide, a lithium cobalt oxide, a lithium manganese oxide, a lithium iron phosphate compound, a cobalt-free lithium manganese oxide, or a combination thereof.

By way of example, the composite oxide may be a compound represented by any one of the following formulae: LiₐA_{1-b}X_{b}O_{2-c}D_{c}(0.90≤a≤1.8, 0≤b≤0.5, 0≤c≤0.05); LiₐMn_{2-b}X_{b}O_{4-c}D_{c}(0.90≤a≤1.8, 0≤b≤0.5, 0≤c≤0.05); LiₐNi_{1-b-c}Co_{b}X_{c}O_{2-α}D_{α}(0.90≤a≤1.8, 0≤b≤0.5, 0≤c≤0.5, 0<α<2); LiₐNi_{1-b-c}Mn_{b}X_{c}O_{2-α}D_{α}(0.90≤a≤1.8, 0≤b≤0.5, 0≤c≤0.5, 0<α<2); LiₐNi_{b}Co_{c}L¹_{d}GₑO₂(0.90≤a≤1.8, 0≤b≤0.9, 0≤c≤0.5, 0≤d≤0.5, 0≤e≤0.1); LiₐNiG_{b}O₂(0.90≤a≤1.8, 0.001≤b≤0.1); LiₐCoG_{b}O₂(0.90≤a≤1.8, 0.001≤b≤0.1); LiₐMn_{1-b}G_{b}O₂(0.90≤a≤1.8, 0.001≤b≤0.1); LiₐMn₂G_{b}O₄(0.90≤a≤1.8, 0.001≤b≤0.1); LiₐMn_{1-g}G_{g}PO₄(0.90≤a≤1.8, 0≤g≤0.5); and Li_{(3-f)}Fe₂(PO₄)₃(0≤f≤2); LiₐFePO₄(0.90≤a≤1.8).

In the above formulae, A is Ni, Co, Mn, or a combination thereof; X denotes Al, Ni, Co, Mn, Cr, Fe, Mg, Sr, V, a rare-earth element, or a combination thereof; D is O, F, S, P, or a combination thereof; G is Al, Cr, Mn, Fe, Mg, La, Ce, Sr, V, or a combination thereof; L¹ is Mn, Al, or a combination thereof.

In one or more embodiments, the positive electrode material may be a high nickel-content positive electrode material containing 80 mol% or more, 85 mol% or more, 90 mol% or more, 91 mol% or more, or 94 mol% to 99 mol% of nickel based on 100 mol% of metals excluding lithium in the lithium transition metal composite oxide. The high nickel-content positive electrode material can realize suitably high capacity and thus can be applied to high capacity/high density lithium secondary batteries.

The binder serves to attach (or improve the attachment of) positive electrode material particles to each other while also attaching (or adhering) the positive electrode material to the current collector. The binder may include, for example, polyvinyl alcohol, carboxymethylcellulose, hydroxypropylcellulose, diacetylcellulose, polyvinyl chloride, carboxylated polyvinyl chloride, polyvinyl fluoride, polymers including ethylene oxide, polyvinyl pyrrolidone, polyurethane, polytetrafluoroethylene, polyvinylidene fluoride, polyethylene, polypropylene, styrene-butadiene rubbers, (meth)acrylated styrene-butadiene rubbers, epoxy resins, (meth)acrylic resins, polyester resins, nylon, and/or the like, without being limited thereto.

The conductive material serves to impart conductivity to the electrodes and may be any suitable electrically conductive material that does not cause an undesirable chemical change in cells under construction (e.g., in the battery cells being manufactured). The conductive material may include, for example, carbon materials, such as natural graphite, artificial graphite, carbon black, acetylene black, Ketjen black, carbon fiber, carbon nanofibers, carbon nanotubes, and/or the like; metal-based materials in the form of metal powders and/or metal fibers containing copper, nickel, aluminium, silver, and/or the like; conductive polymers, such as polyphenylene derivatives and/or the like; and mixtures thereof.

The current collector may be Al, without being limited thereto.

The negative electrode includes a current collector and a negative electrode material layer arranged on the current collector. The negative electrode material layer includes a negative electrode material and may further include a binder and/or a conductive material.

For example, the negative electrode material layer may include 90 wt% to 99 wt% of the negative electrode material, 0.5 wt% to 5 wt% of the binder, and 0 wt% to 5 wt% of the conductive material.

The negative electrode material includes a material allowing reversible intercalation/deintercalation of lithium ions, lithium metal, a lithium metal alloy, a material capable of being doped to lithium and de-doped therefrom, and/or a transition metal oxide.

The material allowing reversible intercalation/deintercalation of lithium ions may include a carbon-based negative electrode material, for example, crystalline carbon, amorphous carbon, or a combination thereof. The crystalline carbon may include, for example, graphite, such as natural graphite and/or artificial graphite, in amorphous, plate, flake, spherical, and/or fibrous form, and the amorphous carbon may include, for example, soft carbon, hard carbon, mesoporous pitch carbides, calcined coke, and/or the like.

As the lithium metal alloy, an alloy of lithium and a metal selected from among Na, K, Rb, Cs, Fr, Be, Mg, Ca, Sr, Si, Sb, Pb, In, Zn, Ba, Ra, Ge, Al and Sn may be used (e.g., Na, K, Rb, Cs, Be, Mg, Ca, Sr, Si, Sb, Pb, In, Zn, Ba, Ge, Al and Sn).

The material capable of being doped to lithium and de-doped therefrom may be an Si-based negative electrode material and/or an Sn-based negative electrode material. The Si-based negative electrode material may be silicon, a silicon-carbon composite, SiOₓ (0<x≤2), Si-Q alloys (where Q is selected from among alkali metals, alkali-earth metals, Group XIII elements, Group XIV elements (excluding Si), Group XV elements, Group XVI elements, transition metals, rare-earth elements, and combinations thereof), or a combination thereof. The Sn-based negative electrode material may be Sn, SnOₓ (0<x≤2) (e.g., SnO₂), an Sn alloy, or a combination thereof.

The silicon-carbon composite may be a composite of silicon and amorphous carbon. According to one or more embodiments, the silicon-carbon composite may be prepared in the form of silicon particles having an amorphous carbon coating formed on the surface thereof. For example, the silicon-carbon composite may include secondary particles (cores) composed of primary silicon particles and an amorphous carbon coating layer (shell) formed on the surface of the secondary particle. The amorphous carbon may also be placed between the primary silicon particles such that, for example, the primary silicon particles are coated with amorphous carbon. The secondary particles may be dispersed in an amorphous carbon matrix.

The silicon-carbon composite may further include crystalline carbon. For example, the silicon-carbon composite may include a core containing crystalline carbon and silicon particles, and an amorphous carbon coating layer formed on the core.

The Si-based negative electrode material and/or the Sn-based negative electrode material may be used in combination with the carbon-based negative electrode material.

The binder serves to attach (or improve the attachment of) the negative electrode material particles to each other while attaching (e.g., adhering) the negative electrode material to the current collector. The binder may be a non-aqueous binder, an aqueous binder, a dry binder, or a combination thereof.

The non-aqueous binder may include polyvinyl chloride, carboxylated polyvinyl chloride, polyvinyl fluoride, ethylene propylene copolymers, polystyrene, polyurethane, polytetrafluoroethylene, polyvinylidene fluoride, polyethylene, polypropylene, polyamideimide, polyimide, or a combination thereof.

The aqueous binder may be selected from the group consisting of styrene-butadiene rubbers, (meth)acrylated styrene-butadiene rubbers, (meth)acrylonitrile-butadiene rubbers, (meth)acrylic rubbers, butyl rubbers, fluorinated rubbers, polyethylene oxide, polyvinyl pyrrolidone, polyepichlorohydrin, polyphosphazene, poly(meth)acrylonitrile, ethylene propylene diene copolymers, polyvinyl pyridine, chlorosulfonated polyethylene, latex, polyester resins, (meth)acryl resins, phenol resins, epoxy resins, polyvinyl alcohol, and combinations thereof.

When the aqueous binder is used as the negative electrode binder, a cellulose-based compound capable of imparting viscosity may be further included. The cellulose-based compound may be a mixture of carboxymethylcellulose, hydroxypropyl methylcellulose, methylcellulose, and/or alkali metal salts thereof. The alkali metal may be Na, K, and/or Li.

The dry binder may be a fibrous polymeric material and may include, for example, polytetrafluoroethylene, polyvinylidene fluoride, a polyvinylidene fluoride-hexafluoropropylene copolymer, polyethylene oxide, or a combination thereof.

The conductive material serves to impart conductivity to the electrodes and may be any suitable electrically conductive material that does not cause an undesirable chemical change in cells under construction (e.g., in the battery cell being manufactured). For example, the conductive material may include, for example, carbon materials, such as natural graphite, artificial graphite, carbon black, acetylene black, Ketjen black, carbon fibers, carbon nanofibers, carbon nanotubes, and/or the like; metal-based materials in the form of metal powders and/or metal fibers containing copper, nickel, aluminium, silver, and/or the like; conductive polymers, such as polyphenylene derivatives and/or the like; or mixtures thereof.

The negative electrode current collector may be selected from among copper foil, nickel foil, stainless steel foil, titanium foil, nickel foam, copper foam, a conductive metal-coated polymer base, and combinations thereof.

The electrolyte for lithium secondary batteries includes a non-aqueous organic solvent and a lithium salt.

The non-aqueous organic solvent acts as a medium through which ions involved in electrochemical reaction of a cell can move.

The non-aqueous organic solvent may be a carbonate-based solvent, an ester-based solvent, an ether-based solvent, a ketone-based solvent, an alcohol-based solvent, a non-amphoteric solvent, or a combination thereof.

The carbonate-based solvent may include dimethyl carbonate (DMC), diethyl carbonate (DEC), dipropyl carbonate (DPC), methyl propyl carbonate (MPC), ethyl propyl carbonate (EPC), methyl ethyl carbonate (MEC), ethylene carbonate (EC), propylene carbonate (PC), and/or butylene carbonate (BC).

The ester-based solvent may include methyl acetate, ethyl acetate, n-propyl acetate, dimethyl acetate, methyl propionate, ethyl propionate, decanolide, mevalonolactone, valerolactone, caprolactone, and/or the like.

The ether-based solvent may include dibutyl ether, tetraglyme, diglyme, dimethoxyethane, 2-methyltetrahydrofuran, 2,5-dimethyltetrahydrofuran, tetrahydrofuran, and/or the like. In one or more embodiments, the ketone-based solvent may include cyclohexanone and/or the like. The alcohol-based solvent may include ethyl alcohol, isopropyl alcohol, and/or the like, and non-amphoteric solvent may include nitriles, such as R-CN (where R is a straight, branched or cyclic hydrocarbon group having 2 to 20 carbon atoms and may include double bonds, aromatic rings, and/or ether groups); amides, such as dimethylformamide; dioxolanes, such as 1,3-dioxolane, 1,4-dioxolane, and/or the like; sulfolanes; and/or the like.

The non-aqueous organic solvent may be used alone or as a mixture of two or more solvents.

As the carbonate-based solvent, a mixture of a cyclic carbonate and a chained (e.g., linear) carbonate may be used, and the cyclic carbonate and the chained carbonate may be mixed in a volume ratio of 1:1 to 1:9.

The lithium salt is a substance that is soluble in an organic solvent and serves as a source of lithium ions in a battery, enabling or facilitating the operation of a lithium secondary battery while facilitating transfer of the lithium ions between the positive electrode and the negative electrode. Examples of the lithium salts may include at least one selected from among LiPF₆, LiBF₄, LiSbF₆, LiAsFe, LiClO₄, LiAlO₂, LiAlCl₄, LiPO₂F₂, LiCl, Lil, LiN(SO₃C₂F₅)₂, Li(FSO₂)₂N (lithium bis(fluorosulfonyl)imide (LiFSI), LiC₄F₉SO₃, LiN(CₓF₂ₓ₊₁SO₂)(C_{y}F_{2y+1}SO₂) (where x and y are integers of 1 to 20), lithium trifluoromethane sulfonate, lithium tetrafluoroethane sulfonate, lithium difluorobis(oxalato)phosphate (LiDFOB), and lithium bis(oxalato)borate (LiBOB).

Depending on the type or kind of lithium secondary battery, a separator may be interposed between the positive electrode and the negative electrode. For such a separator, polyethylene, polypropylene, polyvinylidene fluoride, or at least two layers thereof may be used, as well as mixed layers, such as a polyethylene/polypropylene bilayer separator, a polyethylene/polypropylene/polyethylene trilayer separator, a polyethylene/polyethylene/polypropylene trilayer separator, and/or the like.

The separator may include a porous substrate and a coating layer that includes an organic material, an inorganic material, or a combination thereof on one or both (e.g., simultaneously) surfaces (e.g., opposite surfaces) of the porous substrate.

The porous substrate may be a polymer layer formed of a polymer selected from among polyolefins, such as polyethylene polypropylene, and/or the like; polyesters, such as polyethylene terephthalate, polybutylene terephthalate, and/or the like; polyacetal; polyamides; polyimides; polycarbonates; polyether ketones; polyarylether ketones; polyetherimides; polyamideimides; polybenzimidazole; polyethersulfone; polyphenylene oxides; cyclic olefin copolymers; polyphenylene sulfides; polyethylene naphthalate; glass fiber, and polytetrafluoroethylene (Teflon^{™}), , copolymers thereof, and/or mixtures thereof.

The organic material may include a polyvinylidene fluoride polymer and/or a (meth)acrylic polymer.

The inorganic material may include inorganic particles selected from among Al₂O₃, SiO₂, TiO₂, SnO₂, CeO₂, MgO, NiO, CaO, GaO, ZnO, ZrO₂, Y₂O₃, SrTiOs, BaTiOs, Mg(OH)₂, boehmite, and combinations thereof, without being limited thereto.

The organic material and the inorganic material may be present in a mixed state in one coating layer or may be present in the form of a stack structure of a coating layer including the organic material and a coating layer including the inorganic material.

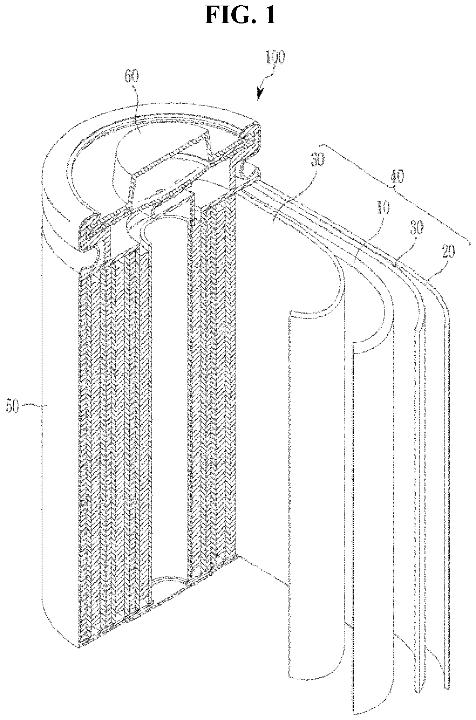

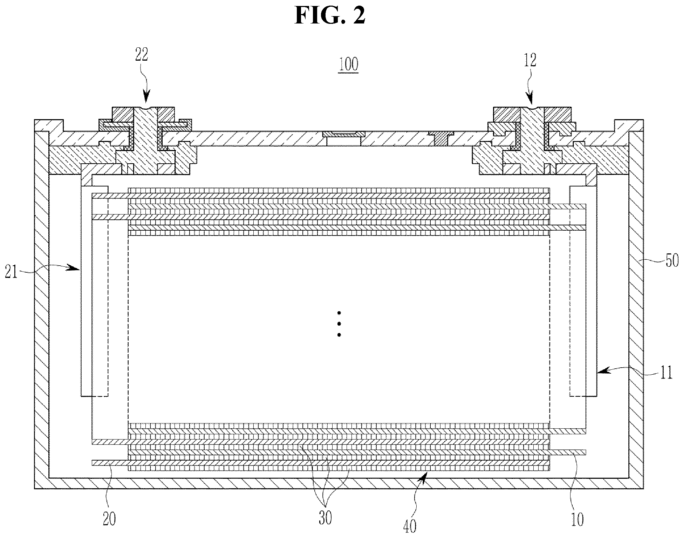

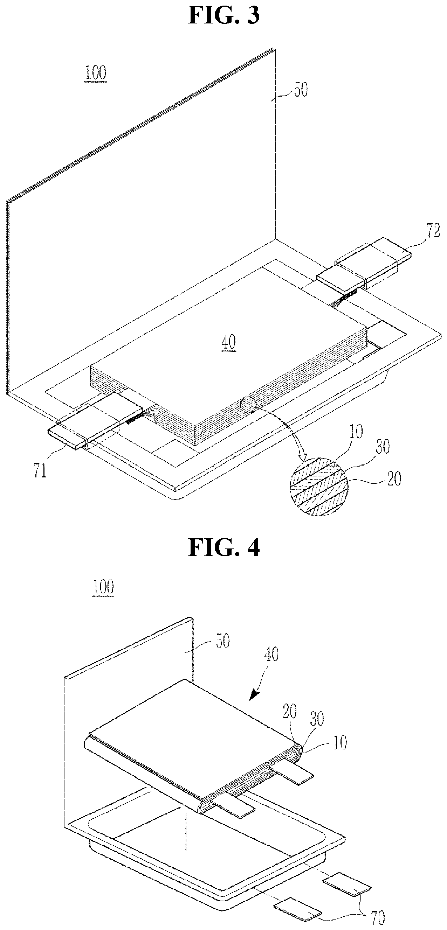

Lithium secondary batteries may be classified into a cylindrical secondary battery, a faceted secondary battery, a pouch type or kind secondary battery, a coin type or kind secondary battery, and/or the like based on the shapes thereof. FIG. 1 to FIG. 4 are schematic views of lithium secondary batteries according to one or more embodiments of the present disclosure, in which FIG. 1 shows a cylindrical secondary battery, FIG. 2 shows a faceted secondary battery, and FIG. 3 and FIG. 4 each show a pouch-type or kind secondary battery. Referring to FIG. 1 to FIG. 4, a lithium secondary battery 100 may include an electrode assembly 40 in which a separator 30 is interposed between a positive electrode 10 and a negative electrode 20, and a case 50 that receives the electrode assembly 40 therein. The positive electrode 10, the negative electrode 20, and the separator 30 may be embedded with an electrolyte. The lithium secondary battery 100 may include a sealing member 60 that seals the case 50, as shown in FIG. 1. In one or more embodiments, as shown in FIG. 2, the lithium secondary battery 100 may include a positive electrode lead tab 11, a positive electrode terminal 12, a negative electrode lead tab 21, and a negative electrode terminal 22. Referring to FIG. 3 and FIG. 4, the lithium secondary battery 100 may include electrode tabs 70 that may include a positive electrode tab 71 and a negative electrode tab 72, which act as electrical pathways conducting current formed in the electrode assembly 40 to the outside.

Lithium secondary batteries according to one or more embodiments of the present disclosure may be applied to automobiles (e.g., as a driving power source for hybrid or electric vehicles), mobile phones, and/or one or more suitable other electrical devices, without being limited thereto.

Next, the present disclosure will be described in more detail with reference to examples. However, it should be understood that these examples are provided for illustration only and should not be construed in any way as limiting the disclosure.

### Preparative Example 1-1: Preparation of first secondary particle LiNi_{0.94}Co_{0.04}Al_{0.02}O₂ having an average particle diameter of 18 µm

An aluminium precursor, Al₂(SO₄)₃(H₂O)₁₈, was mixed with NaOH, NH₄OH, and water to prepare an aqueous solution of the aluminium precursor.

In one or more embodiments, a nickel precursor, NiSO₄(H₂O)₆, and a cobalt precursor, CoSO₄(H₂O)₇, were each mixed with water to prepare an aqueous solution of the nickel precursor and an aqueous solution of the cobalt precursor, respectively.

With the aqueous solution of the aluminium precursor placed in a reactor, the aqueous solution of the nickel precursor and the aqueous solution of the cobalt precursor were dropwise added to the reactor to obtain a reaction mixture, followed by stirring the reaction mixture for 10 to 20 hours. The content (e.g., amount) of each of the nickel precursor, the cobalt precursor and the aluminium precursor in the reaction mixture was stoichiometrically controlled or selected until the molar ratio of nickel, cobalt and aluminium reached 94:4:2.

An aqueous solution of sodium hydroxide was added to the reaction mixture to adjust the pH of the reaction mixture to 10 to 12. A resulting product obtained by filtering and washing the resulting precipitates was dried at 100°C in a vacuum, thereby preparing Ni_{0.94}Co_{0.04}Al_{0.02}(OH)₂ powder, a nickel cobalt aluminium hydroxide, through co-precipitation.

After mixing the obtained nickel cobalt aluminium hydroxide with lithium hydroxide (LiOH) as a lithium precursor in a bowl, the mixture was placed in a furnace and then subjected to heat treatment at 730°C for 20 hours while supplying O₂ to the furnace, thereby preparing a nickel-based active material. The content (e.g., amount) of each of the nickel cobalt aluminium hydroxide and the lithium precursor was controlled or selected such that the mixing ratio of metals to lithium reached 1:1.03.

The prepared nickel-based active material was in the form of secondary particles (NCA, LiNi_{0.94}Co_{0.04}Al_{0.02}O₂) having an average particle diameter of 18 µm and composed of two or more primary particles having an average particle diameter of 1 µm or less.

### Preparative Example 1-2: Preparation of first secondary particle

First secondary particles were prepared in substantially the same manner as in Example 1 except for the content (e.g., amount) of each of the nickel precursor, the cobalt precursor, and the aluminium precursor, the heat treatment temperature and the heat treatment time were varied to obtain the particle as described in Table 1.

### Preparative Example 1-3: Preparation of first secondary particle

First secondary particles were prepared in substantially the same manner as in Example 1 except for the content (e.g., amount) of each of the nickel precursor, the cobalt precursor, and the aluminium precursor, the heat treatment temperature and the heat treatment time were varied to obtain the particle as described in Table 1.

### Preparative Example 2: Preparation of second secondary particle LiNi_{0.89}Co_{0.09}Al_{0.02}O₂ having an average particle diameter of 10.4 µm

An aluminium precursor, Al₂(SO₄)₃(H₂O)₁₈, was mixed with NaOH, NH₄OH, and water to prepare an aqueous solution of the aluminium precursor.

A nickel precursor, NiSO₄(H₂O)₆, and a cobalt precursor, CoSO₄(H₂O)₇, were mixed with water to prepare an aqueous solution of the nickel precursor and an aqueous solution of the cobalt precursor, respectively.

With the aqueous solution of the aluminium precursor placed in a reactor, the aqueous solution of the nickel precursor and the aqueous solution of the cobalt precursor were dropwise added to the reactor to obtain a reaction mixture, followed by stirring the reaction mixture for 10 to 20 hours. The content (e.g., amount) of each of the nickel precursor, the cobalt precursor and the aluminium precursor in the reaction mixture was stoichiometrically controlled or selected until the molar ratio of nickel, cobalt and aluminium reached 89:9:2.

An aqueous solution of sodium hydroxide was added to the reaction mixture to adjust the pH of the reaction mixture to 10 to 12. A resulting product obtained by filtering and washing the resulting precipitates was dried at 100°C in a vacuum, thereby preparing Ni_{0.89}Co_{0.09}Al_{0.02}(OH)₂ powder, a nickel cobalt aluminium hydroxide.

After mixing the nickel cobalt aluminium hydroxide with lithium hydroxide (LiOH), the mixture was placed in a furnace and then subjected to heat treatment at 730°C for 20 hours while supplying O₂ to the furnace, thereby preparing a nickel-based active material. The content (e.g., amount) of each of the nickel cobalt aluminium hydroxide and the lithium precursor was controlled or selected such that the mixing ratio of metals to lithium reached 1:1.03.

The nickel-based active material prepared by the above method was in the form of secondary particles (NCA, LiNi_{0.89}Co_{0.09}Al_{0.02}O₂) having an average particle diameter of 10.4 µm and composed of two or more primary particles having an average particle diameter of 1 µm or less.

### Preparative Example 3-1: Preparation of one-body particle, LiNi_{0.97}Co_{0.02} Al_{0.01}O₂ (NCA), having an average particle diameter of 4.1 µm

An aluminium precursor, Al₂(SO₄)₃(H₂O)₁₈, was mixed with NaOH, NH₄OH, and water to prepare an aqueous solution of the aluminium precursor.

A nickel precursor, NiSO₄(H₂O)₆, and a cobalt precursor, CoSO₄(H₂O)₇, were mixed with water to prepare an aqueous solution of the nickel precursor and an aqueous solution of the cobalt precursor, respectively.

With the aqueous solution of the aluminium precursor placed in a reactor, the aqueous solution of the nickel precursor and the aqueous solution of the cobalt precursor were dropwise added to the reactor to obtain a reaction mixture, followed by stirring the reaction mixture for 10 to 20 hours. The content (e.g., amount) of each of the nickel precursor, the cobalt precursor and the aluminium precursor in the reaction mixture was stoichiometrically controlled or selected until the molar ratio of nickel, cobalt and aluminium reached 97:2:1.

An aqueous solution of sodium hydroxide was added to the reaction mixture to adjust the pH of the reaction mixture to 10 to 12. A resulting product obtained by filtering and washing the resulting precipitates was dried at 100°C in a vacuum, thereby preparing Ni_{0.97}Co_{0.02}Al_{0.01}O₂(OH)₂ powder, a nickel cobalt aluminium hydroxide.

After mixing the nickel cobalt aluminium hydroxide with lithium hydroxide (LiOH), the mixture was placed in a furnace and then subjected to heat treatment at 900°C for 20 hours while supplying O₂ to the furnace, thereby preparing a nickel-based active material. The content (e.g., amount) of each of the nickel cobalt aluminium hydroxide and the lithium precursor was controlled or selected such that the mixing ratio of metals to lithium reached 1:1.05.

The nickel-based active material prepared by the above method was in the form of one-body particles (NCA, LiNi_{0.97}Co_{0.02}Al_{0.01}O₂) having an average particle diameter of 4.1 µm.

### Preparative Examples 3-2 to 3-4: Preparation of one-body particle

One-body particles were prepared in substantially the same manner as in Example 3-1 except for the content (e.g., amount) of each of the nickel precursor, the cobalt precursor, and the aluminium precursor, the heat treatment temperature and the heat treatment time were varied to obtain the particle as described in Table 1.

Details of the particles obtained in the above preparative examples are as follows.

**Table 1**

| | Kind of particle | Particle Composition | Average particle diameter (µm) | Nickel content (mol%) |
|---|---|---|---|---|
| Preparative Example 1-1 | First secondary particle | LiNi_{0.94}Co_{0.04}Al_{0.02}O₂ | 18.0 | 94 |
| Preparative Example 1-2 | First secondary particle | LiNi_{0.95}Co_{0.04}Al_{0.01}O₂ | 18.1 | 95 |
| Preparative Example 1-3 | First secondary particle | LiNi_{0.97}CO_{0.02}Al_{0.01}O₂ | 17.9 | 97 |
| Preparative Example 2 | Second secondary particle | LiNi_{0.89}Co_{0.09}Al_{0.02}O₂ | 10.4 | 89 |
| Preparative Example 3-1 | One-body particle | LiNi_{0.97}CO_{0.02}Al_{0.01}O₂ | 4.1 | 97 |
| Preparative Example 3-2 | One-body particle | LiNi_{0.91}Co_{0.08}Al_{0.01}O₂ | 3.8 | 91 |
| Preparative Example 3-3 | One-body particle | LiNi_{0.95}Co_{0.03}Al_{0.02}O₂ | 3.8 | 95 |
| Preparative Example 3-4 | One-body particle | LiNi_{0.95}Co_{0.02}Al_{0.03}O₂ | 4.0 | 95 |

### Preparation of positive electrode material for lithium secondary batteries and lithium secondary battery including the positive electrode material

### Example 1

A lithium nickel-based composite oxide was prepared by mixing the first secondary particles prepared in Preparative Example 1-1, the second secondary particles prepared in Preparative Example 2, and the one-body particles prepared in Preparative Example 3-1 in the content (e.g., amount) (in parts by weight) in a mixer, as listed in Table 2.

Then, a first process was carried out by adding distilled water as a solvent and cobalt sulfate (as the cobalt source) to the mixer, and adding the prepared lithium nickel-based composite oxide to the mixer, followed by stirring. The cobalt sulfate was added to the mixer such that the lithium nickel-based composite oxide had a cobalt content (e.g., amount) of 2.5 parts by mole relative to the content (e.g., amount) of all elements in the composite oxide excluding lithium and oxygen. In the first process, after the lithium nickel-based complex oxide was added, sodium hydroxide acting as a precipitant and a pH regulator was added together to clean the mixture for 70 minutes.

In some embodiments, the cobalt source may be, for example, cobalt hydroxide, cobalt carbonate, cobalt sulfate, cobalt oxide, cobalt nitrate, and/or the like.

The resulting product was mixed with a lithium source and was then placed in a calcination furnace to be subjected to heat treatment at about 710°C in an oxygen atmosphere for 15 hours. The lithium source was added to the resulting product such that the resulting product had a lithium content (e.g., amount) of 5 parts by mole relative to the total content (e.g., amount) of all elements excluding lithium and oxygen. Then, the furnace was cooled to room temperature to obtain a final positive electrode material with a cobalt coating layer formed on the surface of the lithium nickel-based complex oxide.

The prepared nickel-based active material was used as a positive electrode material. In the following Table 2, '-' means that the corresponding component was not present.

Positive electrode material slurries were prepared by mixing the positive electrode material, a carbon conductor (Super P) and a polyvinylidene fluoride (PVDF) binder solution. In the active material slurries, the weight ratio of the active material, the conductor and the binder was 98:1:1. The prepared slurries were coated at a loading level of 36 mg/cm² on an aluminium current collector having a thickness of 12 µm using a thick film coater, then dried at 120°C for 1 hour or more, and rolled to prepare positive electrodes.

Graphite powder (Japan carbon) as a negative electrode material and a mixture of styrene butadiene rubber (SBR) and carboxymethyl cellulose (CMC) in a weight ratio of 1:1 were mixed in a weight ratio of 98:2 (weight ratio of the negative electrode material to SBR to CMC was 98:1:1) to prepare negative electrode material slurries.

The prepared negative electrode active material slurries were coated at a loading level of 19.5 mg/cm² on a copper foil collector having a thickness of 8 µm. The coated electrode plate was dried at 100°C for 1 hour or more, and then rolled to prepare negative electrodes having a composite density of 1.66 g/cm³.

Lithium secondary batteries with a capacity of 2,000 mAh were prepared using the positive electrodes and the negative electrodes together with a polyethylene separator (separator, STAR 20, Asahi) and an electrolyte in which 1.15 M LiPF₆ was dissolved in a mixed solvent of EC (ethylene carbonate), EMC (ethyl methyl carbonate) and DMC (dimethyl carbonate) (3:3:4 volume ratio).

### Example 2

A lithium secondary battery was prepared in substantially the same manner as in Example 1 except that the type or kind and content (e.g., amount) of particles in a nickel-based active material were changed, as listed in Table 2.

### Comparative Examples 1 to 4

Lithium secondary batteries were prepared in substantially the same manner as in Example 1 except that the type or kind and content (e.g., amount) of particles in a nickel-based active material were changed, as listed in Table 2.

**Table 2**

| | Average particle diameter (µm) | | | | Nickel content (mol%) | | | | Content (parts by weight) | | | |
|---|---|---|---|---|---|---|---|---|---|---|---|---|
| | First secon dary particl e | Seco nd secon dary particl e | one-body particl e 1 | one-body particl e 2 | First secon dary particl e | Seco nd secon dary particl e | One-body particl e 1 | One-body particl e 2 | First secon dary particl e | Seco nd secon dary particl e | One-body particl e 1 | One-body particl e 2 |
| Examp le 1 | 18 | 10.4 | 4.1 | - | 94 | 89 | 97 | - | 75 | 10 | 15 | - |
| Examp le 2 | 18 | 10.4 | 4.1 | - | 94 | 89 | 97 | - | 80 | 5 | 15 | - |
| Comp arative Examp le 1 | 18 | - | 4.1 | - | 94 | - | 97 | - | 70 | - | 30 | - |
| Comp arative Examp le 2 | 18 | - | 3.8 | 4.0 | 94 | - | 95 | 95 | 80 | - | 15 | 5 |
| Comp arative Examp le 3 | 18.1 | 10.4 | 3.8 | - | 95 | 89 | 91 | - | 75 | 10 | 15 | - |
| Comp arative Examp le 4 | 17.9 | 10.4 | 4.1 | - | 97 | 89 | 97 | - | 70 | 20 | 10 | - |

### Evaluation Example 1: Size analysis of primary particles, secondary particles and one-body particles through scanning electron microscopy (SEM) analysis

SEM images of the positive electrode material for lithium secondary batteries prepared in Example 1 were evaluated. A SEM (Sirion, FEI, USA) was used as a measurement instrument.

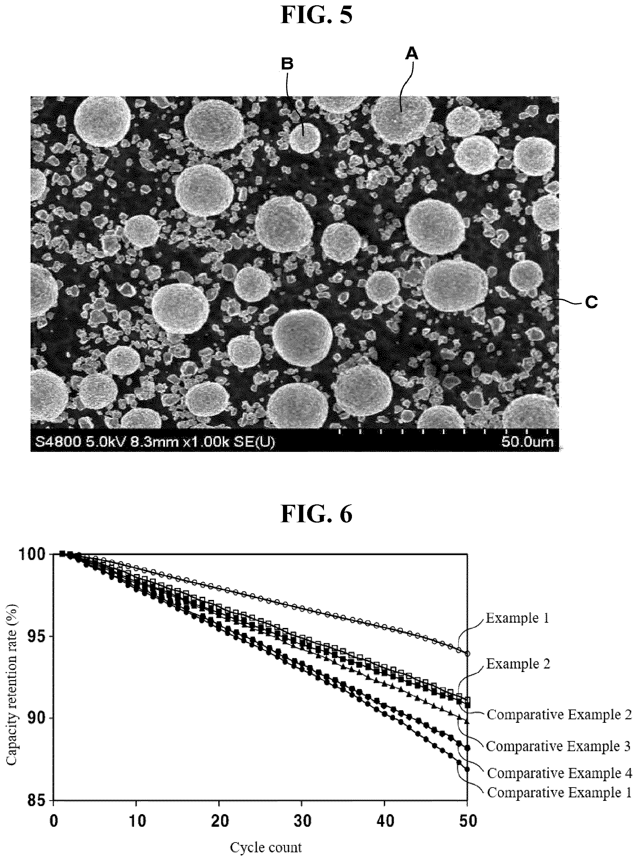

Results of SEM analysis are shown in FIG. 5.

Referring to FIG. 5, it could be seen that the positive electrode material for lithium secondary batteries prepared in Example 1 contains all of the first secondary particles A, the second secondary particles B, and the one-body particles C.

### Evaluation Example 2: Charge capacity, discharge capacity, and efficiency

For each of the lithium secondary batteries of Examples and Comparative Examples, initial discharge capacity was measured by charging the battery at a constant current of 0.2 C from 2.8 V to an upper limit voltage of 4.3 V at 25°C, and charging the battery until the current dropped to an end condition of 0.05 C, followed by discharging at 0.2 C to a discharge end voltage of 3.0V.

A ratio of discharge capacity (one-time discharge capacity) to charge capacity (one-time charge capacity) was calculated as efficiency.

### Evaluation Example 3: High temperature lifespan characteristics

Each of the lithium secondary batteries prepared in Examples and Comparative Examples was charged at a constant current charge 0.2 C at 45°C until the voltage reached 4.3 V, and was then charged at a constant voltage until the current dropped to 0.05 C while maintaining 4.3 V. Then, the battery was discharged at a constant current of 0.2 C until the voltage reached 3.0 V (Formation stage).

Next, the battery was charged at a constant current of 0.7 C until the voltage reached 4.35V, and was then charged at a constant voltage until the current dropped to 0.05 C while maintaining 4.35 V. Then, the battery was discharged at a constant current of 0.5 C until the voltage reached 3.0V (Standard stage).

Each of the lithium secondary batteries that had undergone the formation stage was charged at a constant current of 0.5 C at 25°C and at 45°C until the voltage reached 4.35 V, and was charged at a constant voltage until the current dropped to 0.05 C while maintaining 4.35 V. Then, a cycle of discharging the battery at a constant current of 0.5 C until the voltage dropped to 3.0 V was repeated 50 times. High temperature lifespan was evaluated by a discharge capacity retention rate, which was calculated as the ratio of (1-cycle discharge capacity) to (50-cycle discharge capacity). The high temperature lifespan characteristics obtained from the charge/discharge experiment results are shown in FIG. 6 and Table 3.

**Table 3**

| | Nickel content in nickel-based active material* (mol%) | Charge capacity (mAh/g) | Discharge capacity (mAh/g) | Efficiency (%) | High temperature lifespan (%) |
|---|---|---|---|---|---|
| Example 1 | 94.0 | 245.5 | 214.1 | 87.2 | 93.9 |
| Example 2 | 94.2 | 244.8 | 213.1 | 87.1 | 91.1 |
| Comparative Example 1 | 94.9 | 245.2 | 213.6 | 87.1 | 86.5 |
| Comparative Example 2 | 94.2 | 245.8 | 214.5 | 87.3 | 90.9 |
| Comparative Example 3 | 93.8 | 244.9 | 212.7 | 86.9 | 89.7 |
| Comparative Example 4 | 95.4 | 243.9 | 212.8 | 87.2 | 88.2 |

In Table 3, *: Nickel content is based on total content (e.g., amount) of metals excluding lithium in the nickel-based active material.

As shown in Table 3, it could be seen that the lithium secondary batteries prepared in Examples had not only suitably high efficiency, but also improved high temperature lifespan characteristics. This result can also be seen from FIG. 6. Referring to FIG. 6, it could be seen that at 50 cycles, the lithium secondary batteries prepared in Examples had improved high temperature lifespan characteristics, as compared to the lithium secondary batteries prepared in Comparative Examples.

Although the present disclosure has been described with reference to some embodiments and drawings, it should be understood that the present disclosure is not limited thereto and one or more suitable modifications, changes, alterations, and equivalent embodiments can be made by those skilled in the art without departing from the scope of the present disclosure as set forth in the appended claims and equivalents thereof.

A person of ordinary skill in the art would appreciate, in view of the present disclosure in its entirety, would appreciate that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

### Reference Numerals

| | | | |
|---|---|---|---|
| 100: | Lithium secondary battery | 10: | Positive electrode |
| 11: | Positive electrode lead tab | 12: | Positive electrode terminal |
| 20: | Negative electrode | 21: | Negative electrode lead tab |
| 22: | Negative electrode terminal | 30: | Separator |
| 40: | Electrode assembly | 50: | Case |
| 60: | Sealing member | 70: | Electrode tab |
| 71: | Positive electrode tab | 72: | Negative electrode tab |

## Claims

1. A positive electrode material comprising:
i) a first secondary particle having a size in a range of 13 µm to 20 µm and comprising an agglomerate of primary particles having a size in a range of 1 µm or less;
ii) a second secondary particle having a size in a range of 7 µm to 13 µm and comprising an agglomerate of primary particles having a size in a range of 1 µm or less; and
iii) a one-body particle having a size in a range of 1 µm to 7 µm and comprising primary particles,
wherein a nickel content of each of the first secondary particle, the second secondary particle, and the one-body particle satisfies Relation 1: nickel content of the one-body particle > nickel content of the first secondary particle > nickel content of the second secondary particle.

2. The positive electrode material as claimed in claim 1, wherein the positive electrode material satisfies Relation 2: size of the first secondary particle > size of the second secondary particle > size of the one-body particle.

3. The positive electrode material as claimed in claim 1 or claim 2, wherein the positive electrode material has a nickel content of 94 mol% or more based on a total content of metals in the positive electrode material excluding lithium.

4. The positive electrode material as claimed in any one of claims 1 to 3, wherein:
(i) the first secondary particle has the nickel content of 85 mol% to 97 mol%; and/or
(ii) the second secondary particle has the nickel content of 80 mol% to 90 mol%; and/or
(iii) the one-body particle has the nickel content of 90 mol% to 99 mol%.

5. The positive electrode material as claimed in any one of claims 1 to 4, wherein:
(i) the one-body particle is present in an amount of 5 to 25 parts by weight relative to 100 parts by weight of the first secondary particle; and/or
(ii) the first secondary particle is present in an amount of 60 to 80 parts by weight relative to 100 parts by weight of the first secondary particle; and/or
(iii) the second secondary particle is present in an amount of 5 to 35 parts by weight relative to 100 parts by weight of the first secondary particle.

6. The positive electrode material as claimed in any one of claims 1 to 5, wherein the first secondary particle, the second secondary particle, and the one-body particle are present in a total amount of 95 wt% or more in the positive electrode material.

7. The positive electrode material as claimed in any one of claims 1 to 6, wherein the first secondary particle has the nickel content of 85 mol% to 97 mol%, the second secondary particle has the nickel content of 80 mol% to 90 mol%, and the one-body particle has the nickel content of 90 mol% to 99 mol%.

8. The positive electrode material as claimed in any one of claims 1 to 7, wherein the first secondary particle is present in an amount of 60 to 80 parts by weight, the second secondary particle is present in an amount of 5 to 35 parts by weight, and the one-body particle is present in an amount of 5 to 25 parts by weight relative to 100 parts by weight of the positive electrode material.

9. The positive electrode material as claimed in any one of claims 1 to 8, wherein a mole ratio of the nickel content of the first secondary particle to the nickel content of the second secondary particle is in a range from 1.01 to 1.06.

10. The positive electrode material as claimed in any one of claims 1 to 9, wherein a mole ratio of the nickel content of the first secondary particle to the nickel content of the one-body particle is in a range from 0.94 to 0.99.

11. The positive electrode material for as claimed in any one of claims 1 to 10, wherein the positive electrode material comprises a compound represented by Formula 1 or a compound represented by Formula 2:
Formula 1 LiₓNi_{1-y}Co_{y}O_{2-z}X_{z},
in Formula 1,
0.9≤x≤1.2, 0<y≤0.2, 0≤z≤0.5, and 0.8≤1-y<1, and
X denotes F, S, P or a combination thereof,
Formula 2 LiₓNi_{1-y-z}Co_{y}M_{z}O₂₋ₐXₐ,
in Formula 2,
0.9≤x≤1.2, 0<y<0.5, 0.8≤1-y-z<1,0≤z≤0.5, 0<y+z≤0.2, and 0≤a<2;
M denotes Mn, Mg, Ca, Sr, Ba, Ti, Zr, Nb, Mo, W, Zn, Al, Si, Cr, Fe, V, a rare-earth element or a combination thereof; and
X denotes F, S, P or a combination thereof.

12. The positive electrode material as claimed in any one of claims 1 to 11, wherein the positive electrode material comprises a compound represented by Formula 3 or a compound represented by Formula 4:
Formula 3 LiₓCoₐNi_{b}Mn_{c}O₂,
in Formula 3, 0.9<x≤1.2, 0<a<0.5, 0.8≤b<1, 0<c<0.5, and a+b+c=1,
Formula 4 LiₓCoₐNi_{b}Al_{c}O₂,
and in Formula 4, 0.9<x≤1.2, 0<a<0.5, 0.8≤b<1, 0<c<0.5, and a+b+c=1.

13. The positive electrode material as claimed in any one of claims 1 to 12, wherein at least one of the first secondary particle, the second secondary particle, or the one-body particle comprises a cobalt coating layer on a surface thereof.

14. The positive electrode material as claimed in any one of claims 1 to 13, wherein the positive electrode material is for lithium secondary batteries.

15. A lithium secondary battery comprising:
a positive electrode comprising the positive electrode material as claimed in any one of claims 1 to 14;
a negative electrode; and
an electrolyte.
